# EUROPEAN PATENT SPECIFICATION

(11) **EP 4 574 748 B1**
(45) Date of publication and mention of the grant of the patent: **08.07.2026**
(21) Application number: 24216750.0
(22) Date of filing: 02.12.2024
(51) Int. Cl.: B81C 1/00, B81B 7/02

(54) **PROCESS FOR MANUFACTURING MICROELECTROMECHANICAL DEVICES WITH CHAMBERS SEALED AT DIFFERENT PRESSURES AND MICROELECTROMECHANICAL DEVICE THEREBY MANUFACTURED**
VERFAHREN ZUR HERSTELLUNG VON MIKROELEKTROMECHANISCHEN BAUELEMENTEN MIT UNTER VERSCHIEDENEN DRÜCKEN ABGEDICHTETEN KAMMERN UND DADURCH HERGESTELLTES MIKROELEKTROMECHANISCHES BAUELEMENT
PROCÉDÉ DE FABRICATION DE DISPOSITIFS MICROÉLECTROMÉCANIQUES AVEC CHAMBRES SCELLÉES À DIFFÉRENTES PRESSIONS ET DISPOSITIF MICROÉLECTROMÉCANIQUE AINSI FABRIQUÉ

(30) Priority: 15.12.2023 IT 202300026853
(43) Date of publication of application: 25.06.2025
(73) Proprietor: STMicroelectronics International N.V., 1228 Plan-les-Ouates, Geneva (CH)
(72) Inventor: VERCESI, Federico, 20134 Milano (IT); ALLEGATO, Giorgio, 20900 Monza (IT); CORSO, Lorenzo, 20871 Ruginello (MB) (IT); AZPEITIA URQUIA, Mikel, 20128 Milano (IT); GARAVAGLIA, Matteo, 20013 Magenta (MI) (IT)
(74) Representative: Studio Torta S.p.A.

(56) References cited:
- US-A1- 2014 117 472
- US-A1- 2014 306 300
- US-A1- 2015 123 217

## Description

### Technical Field

The present invention relates to a process for manufacturing microelectromechanical devices with chambers sealed at different pressures and a microelectromechanical device thereby manufactured.

### Background

As is known, different microelectromechanical devices incorporated and sealed in a same package are used in many applications. For example, it is very common to integrate uniaxial or multiaxial gyroscopes and accelerometers into the same chip and therefore into the same package.

A frequent issue is linked to the fact that the devices may have optimal operating conditions very different from each other, as in the case of gyroscopes and accelerometers. In fact, in order to reduce consumption due to air friction damping, it is preferable to have the gyroscopes work in an environment having low pressure, typically comprised between 0.1 mbar and 1 mbar. The gyroscopes are maintained constantly oscillating in resonance and low-pressure conditions allow the maintenance of the oscillations, reducing damping and dissipated energy. Accelerometers, on the other hand, normally operate under higher pressure conditions, for example between 1 mbar and a few atmospheres. Similar issues also arise with other types of devices operating under different conditions, for example resonators, wake-up systems, geophones or bolometers in combination with gyroscopes or accelerometers.

A possible solution consists in including different devices in a same cavity or chamber of the package, wherein a pressure level corresponding to a trade-off between the preferred operating pressures is present. Solutions of this type are relatively simple to implement but may be unsatisfactory and affect performance.

According to a different solution, the microelectromechanical devices are included in respective sealed and non-communicating chambers. In practice, the devices, for example gyroscopes and accelerometers, are manufactured in a first wafer, while, in a second wafer, caps are provided, and cavities are formed in positions corresponding to respective sensors. In the cavities intended for devices operating at lower pressure, a layer of an absorbent material or getter is also deposited. When the second wafer is bonded to the first wafer, for example by glass frit bonding or other wafer bonding technique, or at a later time with a dedicated step, the getter is thermally activated and absorbs the non-noble gases present in the chamber, reducing pressure. In this manner chambers sealed at different pressures may be obtained and all the devices may operate under preferred pressure conditions.

However, even this solution is not free from limitations. Firstly, especially when particularly high pressures are desired in one of the chambers, the amount of available gaseous nitrogen may saturate the getter and, in this case, the pressure target in the chamber may not be achieved. On the other hand, to include an amount of getter sufficient to prevent saturation, the dimensions (base area and/or height) of the chamber may be greater than what would be sufficient for the sole microelectromechanical devices.

Furthermore, during manufacturing the getter may be activated prematurely during the wafer bonding steps, before the chambers are completely sealed. In this case, the getter may also absorb gas from the higher-pressure chamber (cross-talk), creating a double drawback. On the one hand, in fact, the pressure of the getter-free chamber decreases and in any case the final pressure value is not accurately predictable. On the other hand, the getter may more easily saturate and therefore even in the low-pressure chamber the atmosphere may not reach the desired level.

US 2014/117472 A1 discloses a microelectromechanical device and a process for manufacturing microelectromechanical devices. The microelectromechanical device disclosed in US 2014/117472 A1 comprises a substrate of semiconductor material; a dielectric layer on the substrate; a structural layer of semiconductor material on the dielectric layer; in the structural layer, a first microelectromechanical device and a second microelectromechanical device sealed respectively in a first chamber at a first pressure and in a second chamber at a second pressure, different from the first pressure; a channel traversing the substrate; in the dielectric layer, a first cavity fluidically coupled to the channel, a second cavity fluidically coupled to the first chamber and a fluidic passage between the first cavity and the second cavity; and a sealing layer that closes the fluidic passage and fluidically isolates the first cavity from the second cavity.

According to the process for manufacturing microelectromechanical devices disclosed in US 2014/117472 A1, a dielectric layer and a structural layer are formed on a first semiconductor wafer having a substrate of semiconductor material, the substrate being selectively etchable with respect to the stop layer. A first microelectromechanical device and a second microelectromechanical device are formed in the structural layer and are sealed respectively in a first chamber and a second chamber at a first pressure. The first chamber is fluidically coupled to an external environment through the substrate and is sealed at a second pressure different from the first pressure. In order to fluidically couple the first chamber to the external environment, a cavity fluidically coupled to the first chamber in the dielectric layer and a channel are formed.

Further examples of known microelectromechanical devices and processes to manufacture microelectromechanical devices are disclosed in US 2015/123217 A1 and US 2014/306300 A1.

### Summary

It is therefore an aim of the present invention to provide a microelectromechanical accelerometer that allows the limitations described to be overcome or at least mitigated.

According to the present invention, a process for manufacturing microelectromechanical devices and a microelectromechanical device as defined in claims 1 and 16, respectively, are provided.

### Brief Description of the Figures

For a better understanding of the present invention, preferred embodiments are provided, by way of non-limiting example, with reference to the attached drawings, wherein:
- Figure 1 is a section through a semiconductor wafer in an initial processing step of a process for manufacturing microelectromechanical devices in accordance with an embodiment of the present invention;
- Figure 2 shows an enlarged detail of the section of Figure 1 in a subsequent processing step of the present process;
- Figure 3 is a top-plan view of a further enlarged detail of the wafer of Figure 2;
- Figure 4 is a top-plan view of a detail of a semiconductor wafer in an intermediate processing step of a microelectromechanical process in accordance with a variant of the present invention;
- Figures 5 and 6 show the detail of Figure 2, in subsequent processing steps;
- Figures 7-9 show the section of Figure 1 in subsequent processing steps;
- Figure 10 shows the view of Figure 3 in a subsequent processing step;
- Figures 11-14 show the section of Figure 1 in subsequent processing steps;
- Figure 15 shows the view of Figure 3 in a subsequent processing step;
- Figure 16 is a cross-section through a microelectromechanical device in accordance with an embodiment of the present invention, obtained with the process illustrated in Figures 1-15;
- Figures 17 and 18 show a section through a semiconductor wafer in initial processing steps of a process for manufacturing microelectromechanical devices in accordance with a different embodiment of the present invention;
- Figure 19 shows an enlarged detail of the section of Figure 17 in a subsequent processing step of the present process;
- Figure 20 is a top-plan view of a further enlarged detail of the wafer of Figure 2;
- Figure 21 shows the detail of Figure 19, in subsequent processing steps;
- Figure 22 shows the view of Figure 20 in a subsequent processing step;
- Figures 23-24 show the detail of Figure 19 in subsequent processing steps;
- Figure 25 shows the view of Figure 20 in a subsequent processing step;
- Figures 26-28 show the section of Figure 17 in subsequent processing steps;
- Figure 29 shows the view of Figure 20 in a subsequent processing step;
- Figure 30 is a cross-section through a microelectromechanical device in accordance with a different embodiment of the present invention, obtained with the process illustrated in Figures 17-29.

### Description of Embodiments

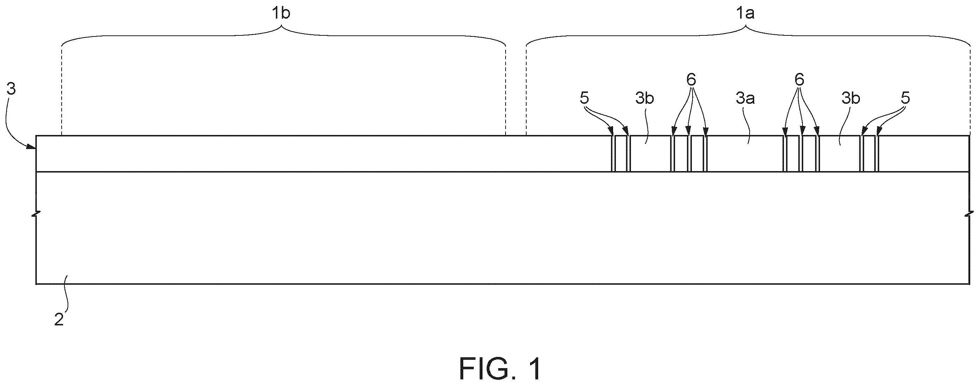

With reference to Figure 1, a semiconductor wafer 1 comprises a substrate 2, for example of monocrystalline silicon. The wafer 1 is intended to accommodate microstructures of microelectromechanical devices and hereinafter it will be referred to as microstructure wafer **1.** More in detail, a first region of the microstructure wafer 1, indicated by 1a, is intended to accommodate a first microelectromechanical sensor operating at a first pressure, for example a gyroscope, and a second region of the microstructure wafer 1, indicated by 1b, is intended to accommodate a second microelectromechanical sensor operating at a second pressure, higher than the first pressure, for example an accelerometer. However, it is understood that other microelectromechanical devices that require different operating pressures, such as resonators and wake-up systems, may be integrated into the substrate **2.**

Initially, a dielectric layer 3 of silicon oxide is deposited on the substrate 2 and is selectively etched in the first region 1a to form first trenches 5 and second trenches 6, which will then serve for the formation of anchors. The first trenches 5 extend continuously along respective closed paths nested one inside the other. In the embodiment described herein, in particular two circular and concentric first trenches 5 are opened.

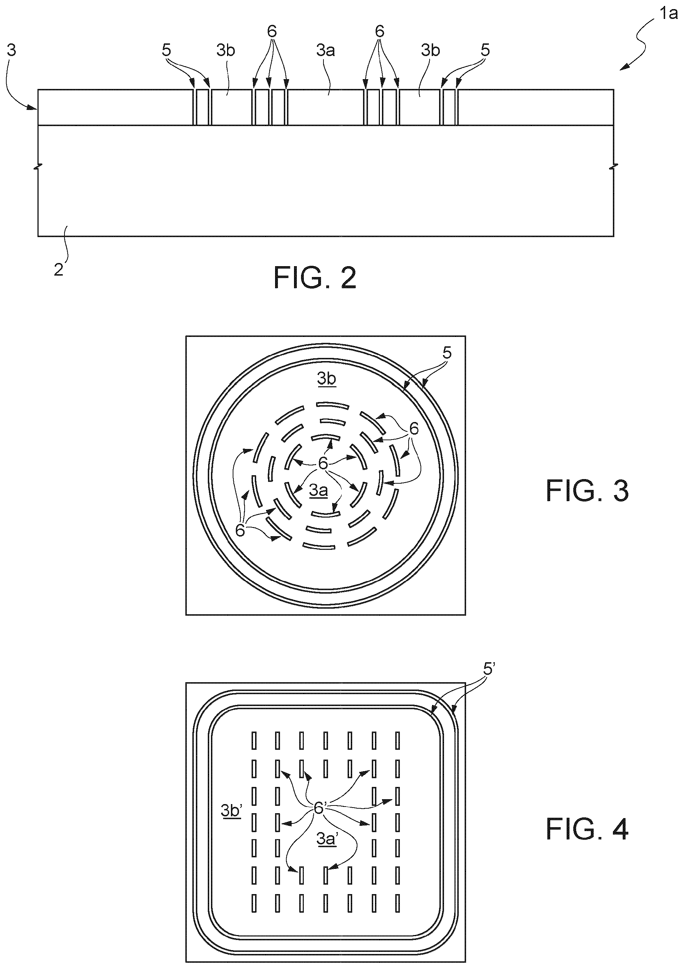

The second trenches 6 are enclosed inside the first trenches 5 and, in one embodiment, are organized in arrays which extend on closed paths L1, ..., LN (three in the illustrated example) nested one in the other. In particular, in one embodiment the closed paths are concentric circumferences and each second trench 6 extends on a portion of a respective closed path L1, ..., LN. Second trenches 6 which extend along a same closed path are separated from each other by portions of the dielectric layer 3. In this manner, a first region 3a and a second region 3b of the dielectric layer 3, respectively internal to the second trenches 6 and comprised between the first trenches 5 and the second trenches 6, are connected to each other through the portions of the dielectric layer 3 which separate consecutive second trenches 6. It is understood, however, that second trenches might not be organized in closed paths and might otherwise be arranged to form anchors, according to design preferences. For example, in the embodiment of Figure 4 the second trenches, here indicated by 6', are aligned in rows.

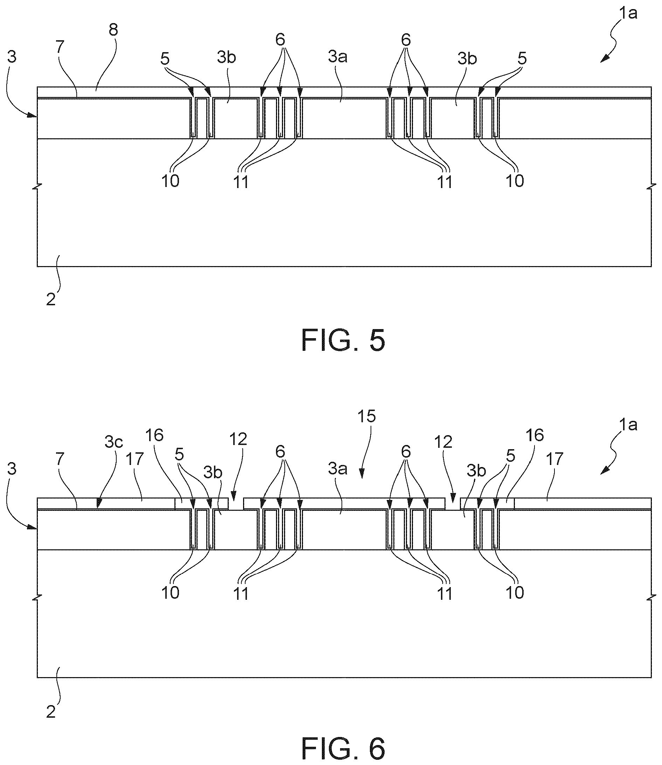

The microstructure wafer 1 is then covered with a stop layer 7 (Figure 5), thin enough to coat the inside of the first trenches 5 and the second trenches 6 without filling them. The stop layer 7 is of a material with respect to which the silicon (or, in general, the material forming the substrate 2) is selectively etchable, for example alumina.

After the stop layer 7, a connection and anchoring layer 8, for example of polycrystalline silicon, is deposited on the microstructure wafer 1 and fills the first trenches 5 and the second trenches 6 forming anchoring rings 10 and anchoring pins 11 respectively, in this case with portions of the stop layer 7 which coat the inside of the first trenches 5 and the second trenches **6.** The anchoring pins 11, in particular, are organized in concentric arrays, corresponding to respective closed paths L1, ..., LN. In each array, adjacent anchoring pins 11 are separated by portions of the dielectric layer 3. The dimensions of the second trenches 6 and the distances between consecutive second trenches 6 at least of the innermost array are selected so that the spaces between consecutive anchoring pins 11 may be sealed by a plasma deposition process, as detailed below. For example, the spacing between consecutive anchoring pins 11 may be between 1 µm and 5 µm.

Then (Figure 6), the stop layer 7 and the connection and anchoring layer 8 are defined to open one or more windows 12 between the first region 3a of the dielectric layer 3 and the innermost of the anchoring rings 10 (which corresponds to the innermost of the first trenches 5), so as to expose part of the dielectric layer **3.** In the embodiment of Figure 6, in particular, a single window 12 having annular shape is opened on the second region 3b of the dielectric layer 3. Consequently, a crown portion of the dielectric layer 3, of a shape corresponding to the window 12, is exposed. Alternatively, a plurality of windows may be opened, for example circular and distributed along a circumference.

In a zone radially internal to the window 12, or more precisely over the first portion 3a of the dielectric layer 3 and over the anchoring pins 11 up to an inner edge of the window 12, remaining portions of the connection and anchoring layer 8 form an anchoring pad 13 bonded to the anchoring pins 11. In turn, the anchoring pad 13 forms an anchoring structure 15 with the anchoring pins 11. In practice, the anchoring pad 13 extends on a face 3c of the dielectric layer 3 opposite to the substrate 2; the anchoring pins 11 extend from the anchoring pad 13 to the substrate 2 perpendicular to the face 3c and along respective arcs of circumference parallel to the face 3c.

In this step, the connection and anchoring layer 8 is also shaped to form anchoring pads 16 and conductive lines 17 according to the design preferences for the microelectromechanical devices to be formed in the microstructure wafer 1.

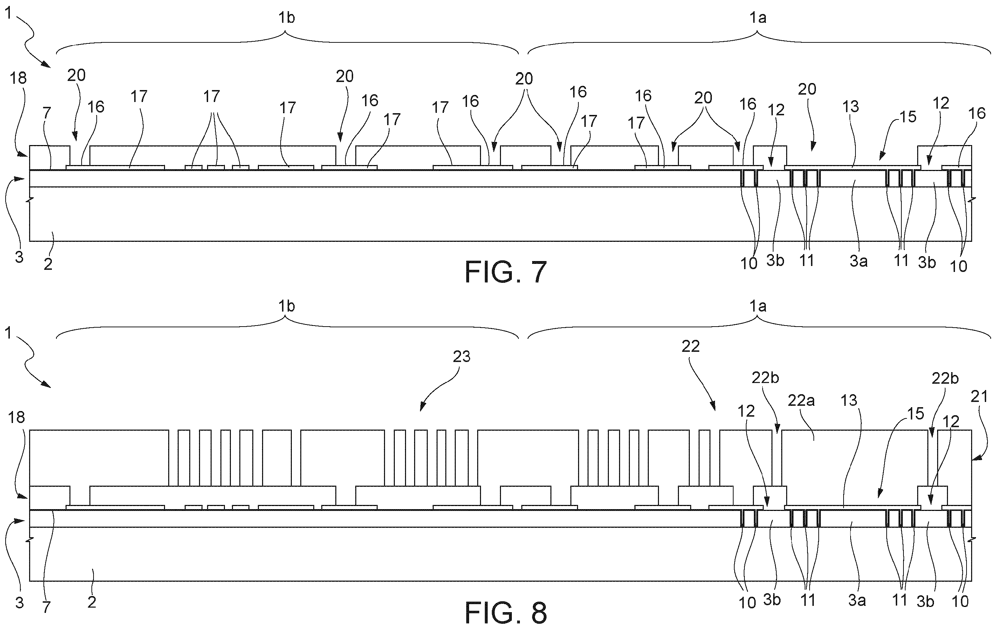

A sacrificial layer 18 of silicon oxide is then deposited on the microstructure wafer 1 (Figure 7), which is in contact with the dielectric layer 3 through the window 12. The sacrificial layer 18 is selectively removed to form anchoring openings 20 over respective anchoring pads 16. Furthermore, one of the anchoring openings 20 exposes the anchoring pad 13 of the anchoring structure 15.

Starting from a seed layer (not shown), a structural layer 21 of polycrystalline silicon is formed on the microstructure wafer 1 (Figure 8) by growth in an epitaxial reactor. The structural layer 21 contacts the anchoring pads 13, 16 through the anchoring openings 20. The structural layer 21 is then defined by an anisotropic trench etching to form fixed and movable parts of a gyroscope 22 in the first region 1a of the microstructure wafer 1 and an accelerometer 23 in the second region 1b. In particular, a fixed or stator portion 22a of the gyroscope 22 is anchored to the anchoring pad 13 of the anchoring structure 15 and is separated from the remaining part of the gyroscope 22 by gaps 22b. However, it is understood that the stator portion 22a of the gyroscope 22 may extend beyond the anchoring structure 15 and be in part anchored to the dielectric layer 3. Furthermore, the gaps 22b reach the portion of the sacrificial layer 18 which is connected to the second region 3a of the dielectric layer 3 through the windows 12.

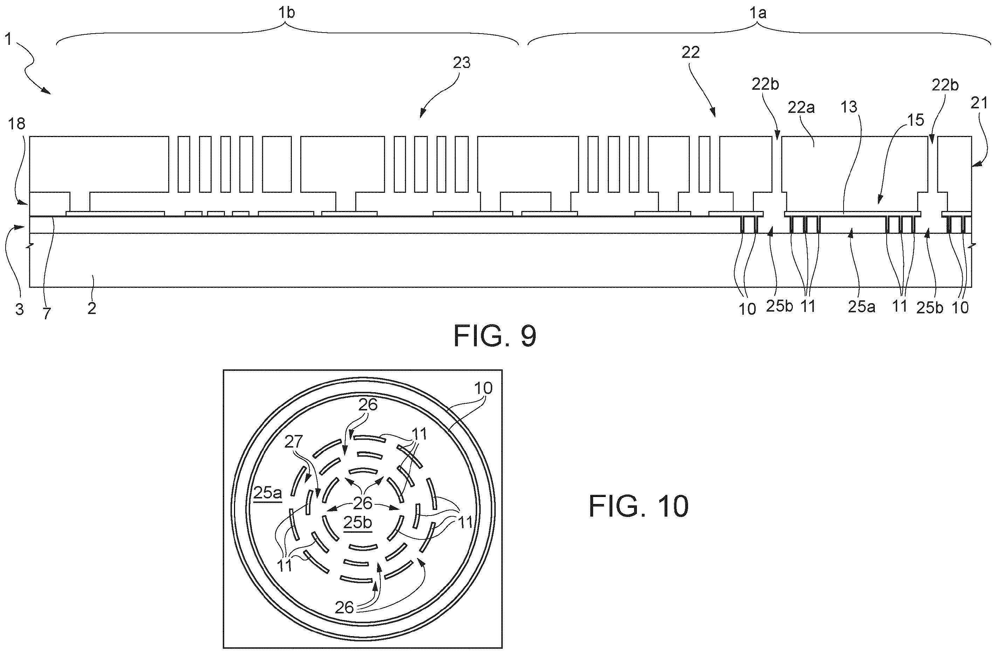

The sacrificial layer 18 is then removed where accessible to free the microstructures of the gyroscope 22 and the accelerometer 23, for example by etching in a hydrofluoric acid bath, as shown in Figure 9. Furthermore, also the part of the dielectric layer 3 internal to the annular anchors 10, which is accessible through the window 12, is removed at the same time. The annular anchors 11, in this step, stop the removal of the dielectric layer 3. When the removal of the sacrificial layer 18 and the dielectric layer 3 is completed, a cavity 25 is defined radially inside the annular anchors 10 between the substrate and the stop layer 7. In particular, a first portion 25a of the cavity 25, radially internal to the anchoring pins 11, communicates fluidically with a second portion 25b of the cavity 25, radially comprised between the annular anchors 10 and the anchoring pins 11. The fluidic connection is obtained through passages 26 between adjacent anchoring pins 11 and channels 27 between concentric arrays of anchoring pins 11, as better illustrated in Figure 10. In turn, after the sacrificial layer 18 has been removed the second portion 25b of the cavity 25 is fluidically coupled to the environment which surrounds the gyroscope 22 through the window 12 and the gaps 22b around the stator portion 22a.

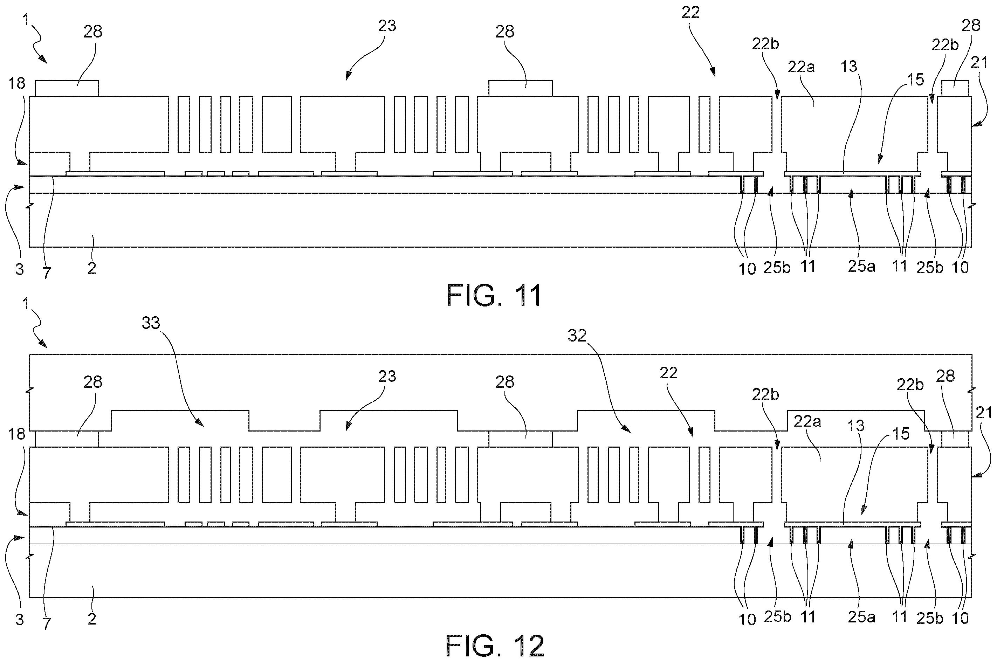

An adhesion layer 28 (Figure 11) is then deposited on portions of the structural layer 21 along closed paths which surround the gyroscope 22 and the accelerometer 23. The adhesion layer 28 may be of any suitable sealing material and used in semiconductor manufacturing processes for wafer bonding, for example and not limited to glass frit, an Al-Ge eutectic alloy, Au-Sn, Au-In, Au-Si, Si-Si, Si-SiO2 alloys.

Then (Figure 12), a cap wafer 30, preliminarily processed on an inner face according to the design preferences, is bonded to the microstructure wafer 1 in a controlled atmosphere at a first pressure P₁, forming a composite wafer 31. By adhering to the adhesion layer 28, the cap wafer 30 seals the gyroscope 22 and the accelerometer 23 respectively inside a first chamber 32 and a second chamber 33, both at the first pressure P₁. In one embodiment, the first pressure P₁ is a design operating pressure of the accelerometer 23, for example between 1 mbar and 5 bar.

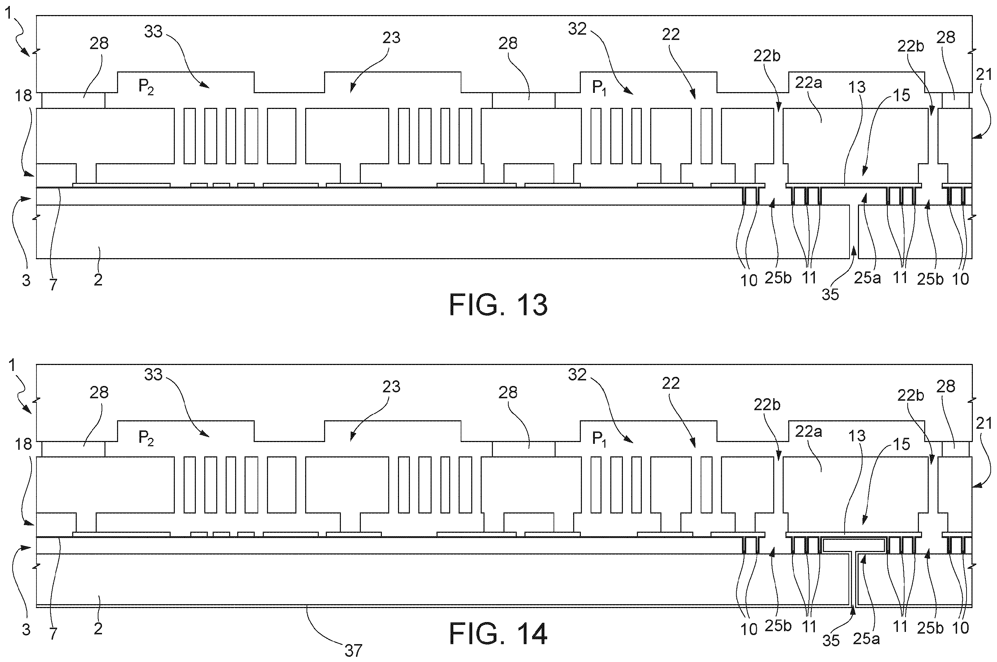

As shown in Figure 13, the substrate 2 of the microstructure wafer 1 is then anisotropically etched through a back side 2a to form a channel 35 aligned with the first portion 25a of the cavity 25. In this step, the etching of the semiconductor material ends on the stop layer 7, which protects the structural layer 21, in particular the fixed or stator portion 22a of the gyroscope 22. In practice, therefore, a fluidic path is defined which puts the first chamber 32, where the gyroscope 22 is arranged, in communication with the outside through the window 12, the second portion 25b of the cavity 25, the passages 26 and the channels 27 between the anchoring pins 11, the first portion 25a of the cavity 25 and the channel 35.

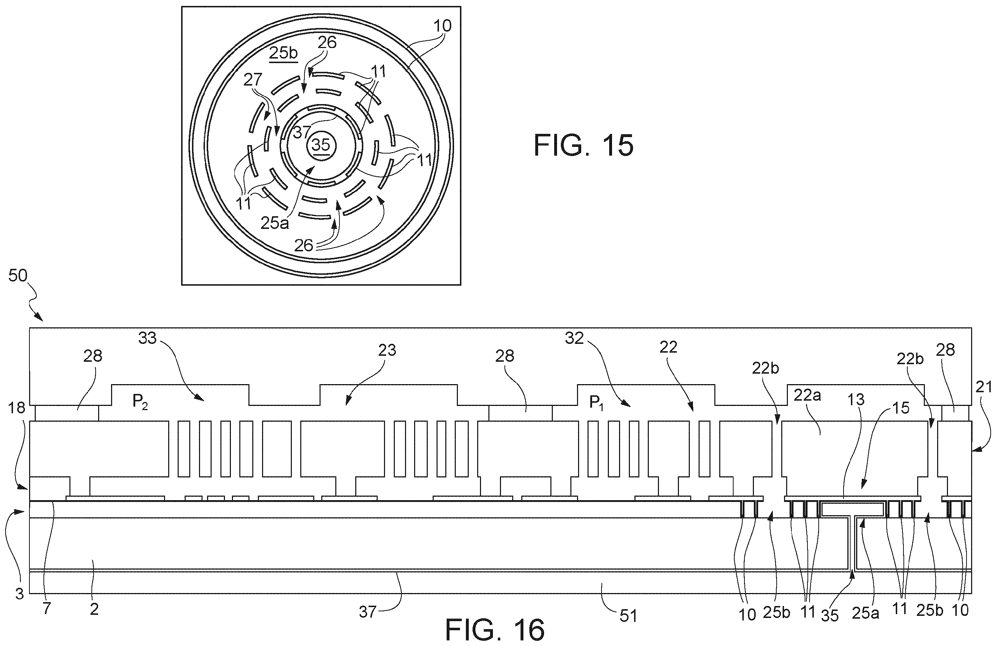

The composite wafer 31 is then placed in an environment at a second pressure P₂, different from the first pressure P₁ and lower in an embodiment, and is sealed (Figures 14 and 15). More precisely, a sealing layer 37 is formed on the back side 2a of the substrate 2, for example by PVD (Physical Vapor Deposition) or PECVD (Plasma-Enhanced Chemical Vapor Deposition) deposition, and penetrates inside the channel 35 and the first region 25a of the cavity 25. Due to the initial spacing between the second trenches 6 (and therefore between the adjacent anchoring pins 11 of the same array), the passages 26 between the anchoring pins 11 close for the deposition of the sealing layer 37 and the first portion 25a is fluidically insulated from the rest of the cavity 25 and from the first chamber 32. The first chamber 32 is therefore sealed at the second pressure P₂, which may be accurately set and maintained.

After final processing steps which may comprise thinning, grinding, definition of contacts and cleaning, the composite wafer 31 is finally diced and divided into dice, each of which comprises a microelectromechanical device 50 of the type illustrated in Figure 16, where it is shown incorporated into a package 51.

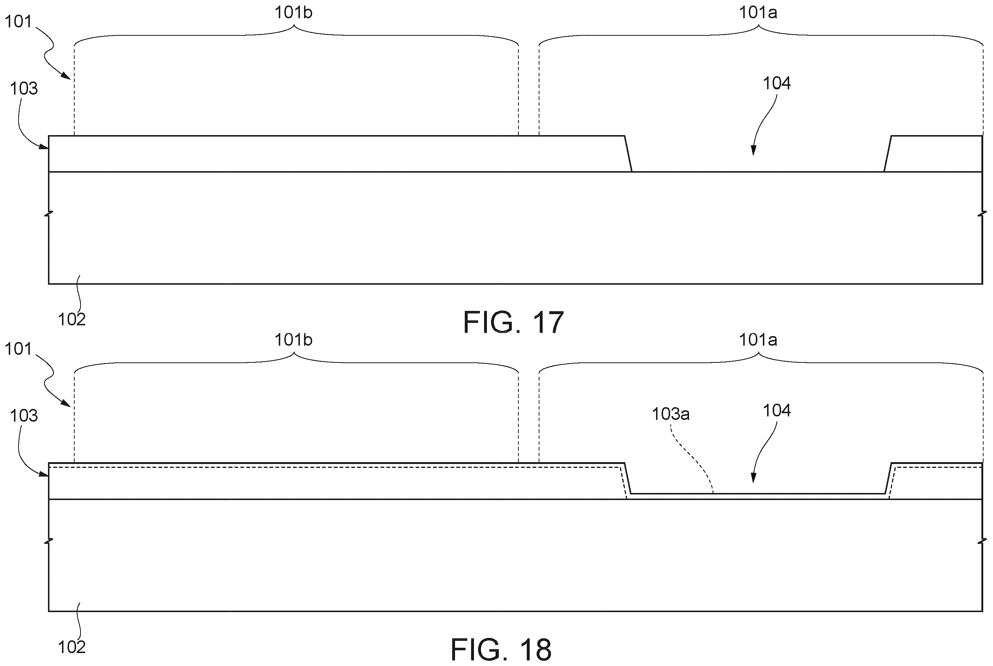

A different embodiment of the present invention will be described below with reference to Figures 17-30. A microstructure wafer 101 comprising a substrate 102 of semiconductor material, for example monocrystalline silicon, is intended to accommodate microstructures of microelectromechanical devices. In particular, a first region of the microstructure wafer 101, indicated by 101a, is intended to accommodate a first microelectromechanical sensor operating at a first pressure, for example a gyroscope, and a second region of the microstructure wafer 101, indicated by 101b, is intended to accommodate a second microelectromechanical sensor operating at a second pressure, higher than the first pressure, for example an accelerometer.

Initially, a dielectric layer 103, for example silicon oxide, is formed on the substrate 102 and selectively etched to open a window 104, for example circular, which exposes a portion of the substrate 102 in the first region 101a of the microstructure wafer.

Then (Figure 18), the dielectric layer 103 is increased by, for example, 0.5 µm or less by thermal oxidation or deposition of further silicon oxide and covers the substrate 102.

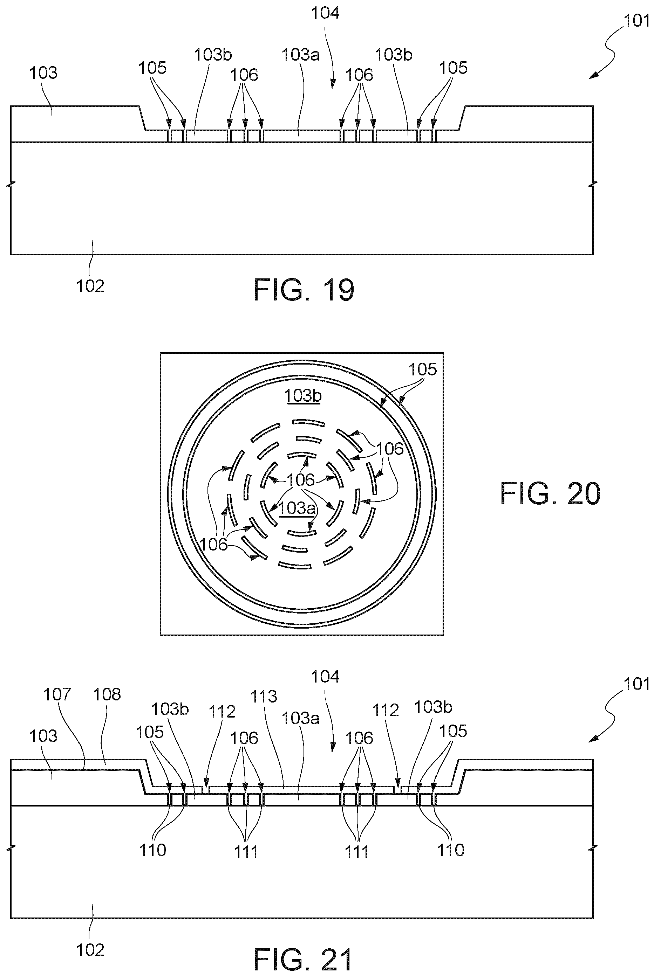

The dielectric layer 103 is selectively etched inside the window 105 to form first trenches 105 and second trenches 106 (Figures 19 and 20), which will then serve for the formation of anchors. The first trenches 105 extend continuously along respective closed paths nested one inside the other. In the embodiment described herein, in particular two circular and concentric first trenches 105 are opened.

The second trenches 106 are enclosed inside the first trenches 105 and, in one embodiment, are organized in arrays which extend on closed paths L1', ..., LN' (three in the illustrated example) nested one in the other. In particular, in one embodiment the closed paths are concentric circumferences and each second trench 106 extends on a portion of a respective closed path L1', ..., LN'. Second trenches 106 which extend along a same closed path are separated from each other by portions of the dielectric layer 103. In this manner, a first region 103a and a second region 103b of the dielectric layer 103, respectively internal to the second trenches 106 and comprised between the first trenches 105 and the second trenches 106, are connected to each other through the portions of the dielectric layer 103 which separate consecutive second trenches 106.

The process then proceeds substantially as already described and will be briefly recalled.

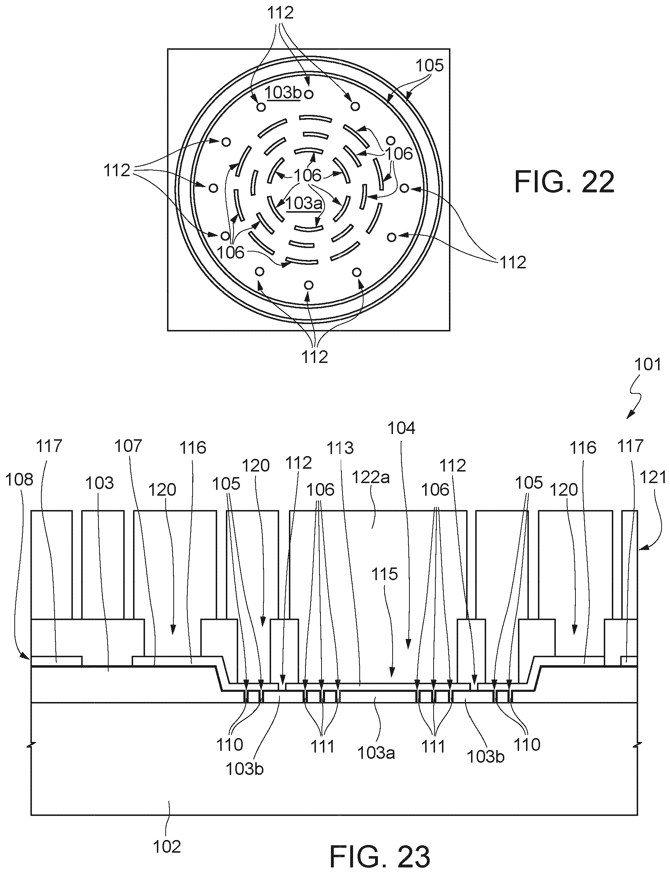

A stop layer 107, for example alumina, and a connection and anchoring layer 108 are deposited on the microstructure wafer 101 (Figures 21 and 22). The stop layer 107 coats the walls of the first trenches 105 and the second trenches 106, leaving a space therewithin which is filled by the connection and anchoring layer 108. Annular anchors 110 in the first trenches 105 and anchoring pins 111 in the second trenches 106 are thus formed. The anchoring pins 111 extend from the anchoring pad 113 to the substrate 102 perpendicular to the face 3c and along respective arcs of circumference parallel to the face 3c.

The stop layer 107 and the connection layer are etched to open windows 112 on the second region 103b of the dielectric layer 103, in this case a plurality of windows 112 distributed along a circumference between the innermost first trench 105 and the outermost array of second trenches 106 (Figure 22).

A portion of the connection and anchoring layer 8 radially internal to the windows 112 forms an anchoring pad 113 bonded to the anchoring pin 111. In turn, the anchoring pad 113 forms an anchoring structure 115 with the anchoring pins 111. In practice, the anchoring pad 113 is depressed with respect to a face of the dielectric layer 103 opposite to the substrate 102.

The connection and anchoring layer 108 is also patterned to form anchoring pads 116 and conductive lines 117 according to the design preferences for the microelectromechanical devices to be formed in the microstructure wafer 101.

A sacrificial layer 118 of silicon oxide is then deposited on the microstructure wafer 101 (Figure 23), which is in contact with the dielectric layer 103 through the windows 112 and is selectively removed to form anchoring openings 120 over respective anchoring pads 116. Furthermore, one of the anchoring openings 120 exposes the anchoring pad 113 of the anchoring structure 115. A structural layer 121 of polycrystalline silicon is formed on the microstructure wafer 101 in contact with the anchoring pads 113, 116 through the anchoring openings 120, by growth in an epitaxial reactor. The structural layer 121 is then patterned to form fixed and movable parts of a gyroscope 122 in the first region 101a of the microstructure wafer 101 and an accelerometer (not shown) in the second region 101b. In particular, a fixed or stator portion 122a of the gyroscope 122 is anchored to the anchoring pad 113 of the anchoring structure 115 and is separated from the remaining part of the gyroscope 122 by gaps 122b which reach the portion of the sacrificial layer 118 which is connected to the second region 103a of the dielectric layer 103 through the windows 112.

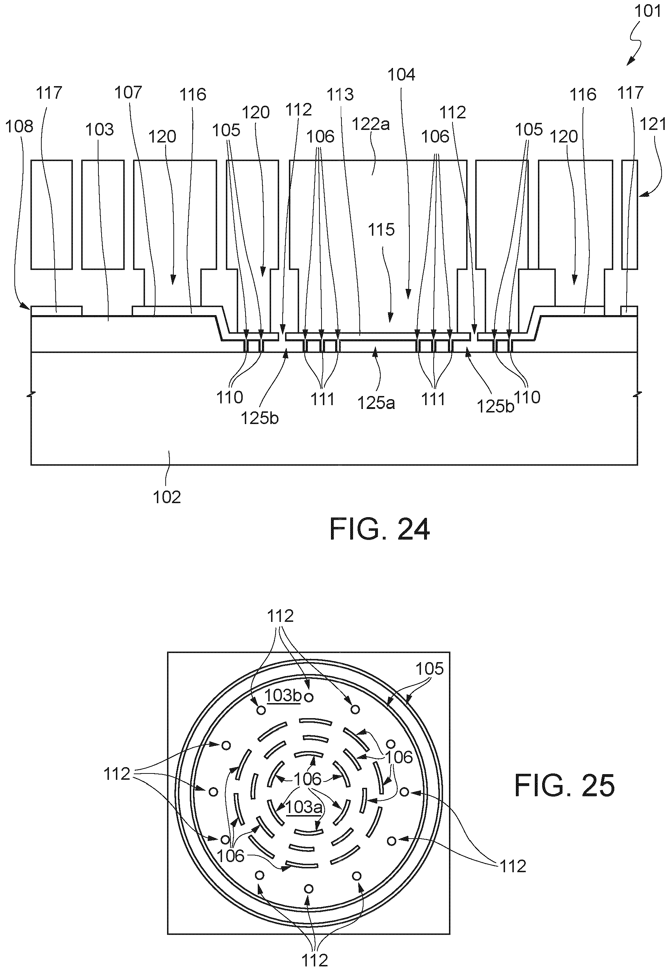

The sacrificial layer 118 is then removed where accessible to release the microstructures of the gyroscope 122 and the accelerometer, as shown in Figure 24. At the same time, the part of the dielectric layer 103 internal to the annular anchors 110 is also removed through the window 112. A cavity 125 is thus defined radially inside the annular anchors 110. A first portion 125a of the cavity 125, radially internal to the anchoring pins 111, communicates fluidically with a second portion 125b of the cavity 125, radially comprised between the annular anchors 110 and the anchoring pins 111, through passages 126 between adjacent anchoring pins 111 and channels 127 between concentric arrays of anchoring pins 111, as better illustrated in Figure 25. Furthermore, the second portion 125b of the cavity 125 is fluidically coupled to the environment which surrounds the gyroscope 122 through the window 112 and the gaps around the fixed portion 122a.

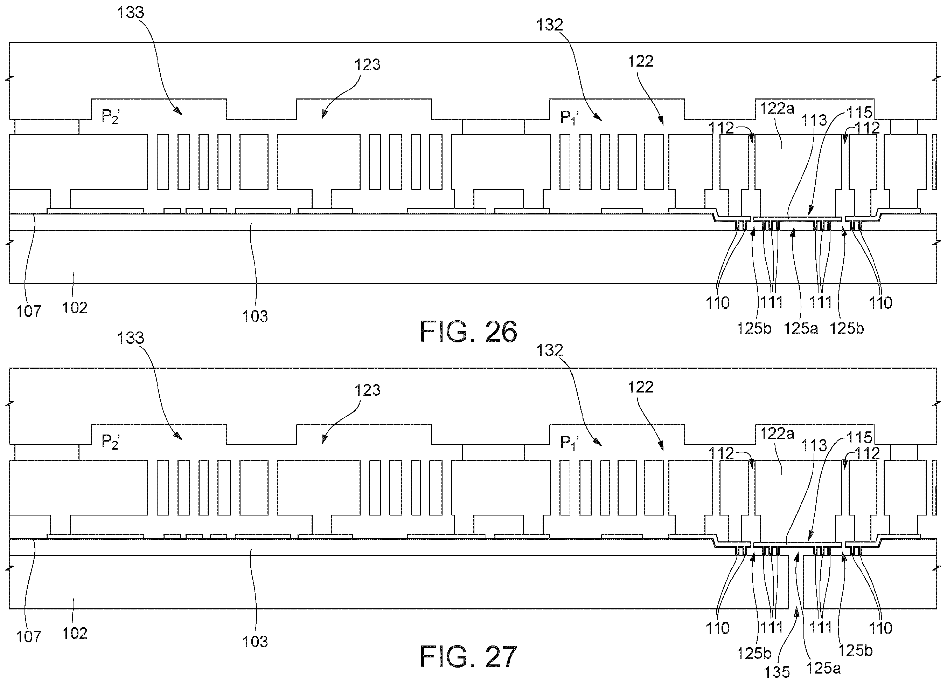

With reference to Figure 26, a cap wafer 130 is bonded to the microstructure wafer 101 using an adhesion layer 128 to seal the gyroscope 122 and the accelerometer (here indicated by 123) respectively inside a first chamber 32 and a second chamber 33, both at a first pressure P₁'.

The substrate 102 of the microstructure wafer 1 is then etched from the back in an anisotropic manner to form a channel 135 aligned with the first portion 125a of the cavity 125 (Figure 27), thus forming a fluidic path that put the first chamber 132, where the gyroscope 122 is arranged, in communication with the outside through the window 112, the second portion 125b of the cavity 125, the passages 126 and the channels 127 between the anchoring pins 111, the first portion 125a of the cavity 125 and the channel 135. In this step, the etching of the semiconductor material ends on the stop layer 107, which protects the structural layer 121, in particular the fixed portion 122a of the gyroscope 122.

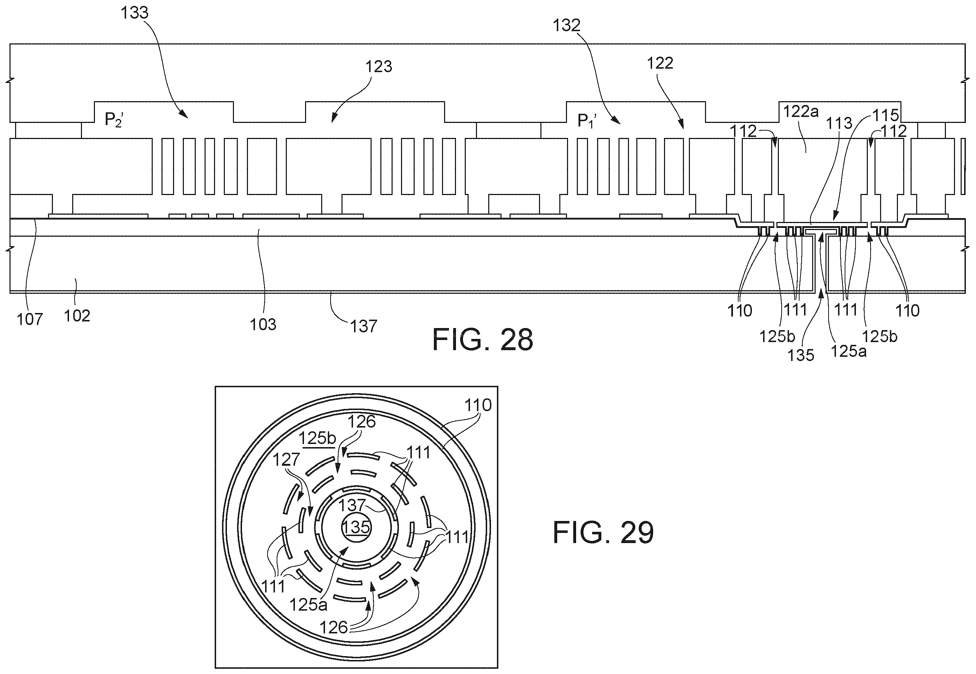

The composite wafer 131 is then placed in an environment at a second pressure P₂', lower than the first pressure P₁', and is sealed (Figures 28 and 29). More precisely, a sealing layer 137 is formed on the back of the substrate 102 by PVD or PECVD deposition and penetrates inside the channel 135 and the first region 125a of the cavity 125. The passages 126 between the anchoring pins 111 close for the deposit of the sealing layer 137 and the first portion 125a is fluidically insulated from the rest of the cavity 125 and the first chamber 132. The first chamber 132 is therefore sealed at the second pressure P₂', which may be accurately set and maintained.

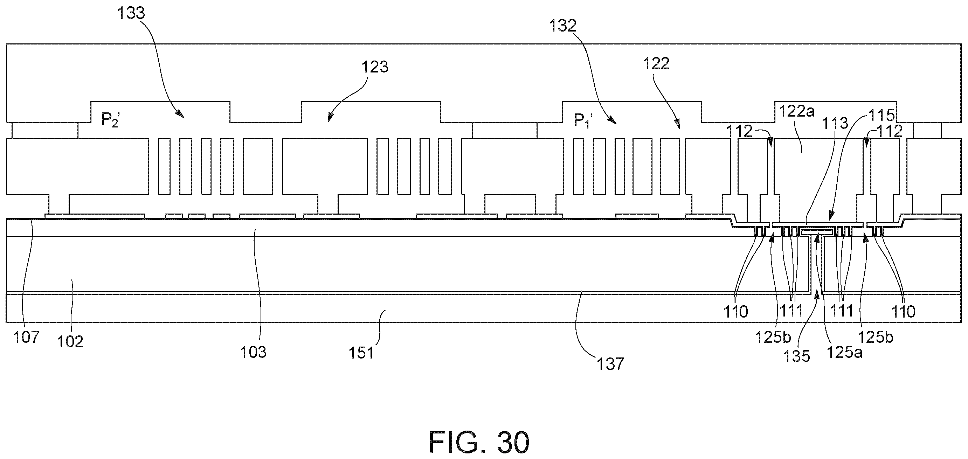

After final processing steps, the composite wafer 131 is finally diced and divided into dice, each of which comprises an integrated microelectromechanical device 150 of the type illustrated in Figure 30, where it is shown incorporated into a package 151.

The process described advantageously allows two different microelectromechanical devices to be sealed in respective chambers at respective accurately controlled pressures, without using getter. The absence of getter, in particular, is advantageous for several reasons. Firstly, space in one of the chambers is clearly saved. This is highly desirable, given the ever-increasing trend towards miniaturization of devices. Secondly, the risk of early getter activation, which might alter the pressure in one or both chambers unpredictably, is completely eliminated. As it has been seen, in fact, the early activation during the steps in which the cap wafer is bonded to the microstructure wafer may cause both the absorption of gas from the high-pressure chamber by cross-talk and the saturation of the getter and therefore a higher-than-expected pressure in the low-pressure chamber. In turn, pressure variations in the chambers may affect the performance of microelectromechanical devices in an uncontrolled manner and, in any case, the actual operating conditions will be different from the preferred design conditions.

The invention instead allows for very accurate control of the pressure in both chambers. The first chamber is in fact sealed exactly at the first pressure and no fluidic connection with the outside is established any longer. In particular, the first chamber is already definitively sealed when the second chamber is equalized at the second pressure and then sealed.

Sealing the second chamber at lower pressure by using PVD or PECVD deposition is further advantageous because it allows the low pressure typically used for this type of processes to be exploited. This condition is particularly suitable for devices operating at very low pressure (in the order of microbars), such as geophones or bolometers.

The process may be implemented mostly using processing steps in any case envisaged for the manufacturing of integrated microelectromechanical devices, simply by suitably designing the etching masks used. Dedicated steps are used in practice only for opening the channel from the back of the composite wafer, without therefore interfering with the processing steps on the front. The process according to the invention therefore does not entail significant increases in complexity and costs, in the face of a notable improvement in performance and a reduction in rejects.

Furthermore, a dedicated etching is not necessary to remove residual portions of the stop layer.

Finally, it is clear that modifications and variations may be made to the microelectromechanical accelerometer described, without departing from the scope of the present invention, as defined in the attached claims.

For example, the cap wafer may be bonded to the microstructure wafer under low pressure conditions and, after putting one of the chambers (e.g. a chamber containing an accelerometer) in communication with the outside through a channel in the substrate and the anchor structures, seal under high pressure conditions.

Furthermore, a plurality of fluidic paths between the outside and one of the two sealed chambers may be opened with the described techniques, in numbers and positions selected according to design preferences.

According to further variants, the stop layer may be selectively removed before depositing the connection layer and left only in the position corresponding to the first portion of the cavity and the channel.

## Claims

1. A process for manufacturing microelectromechanical devices comprising:
on a first semiconductor wafer (1; 101) comprising a substrate (2; 102) of semiconductor material, forming a dielectric layer (3; 103), a structural layer (21; 121) and a stop layer (7; 107) between the dielectric layer (3; 103) and the structural layer (21; 121), the substrate (2; 102) being selectively etchable with respect to the stop layer (7; 107);
forming a first microelectromechanical device (22; 122) and a second microelectromechanical device (23; 123) in the structural layer (21; 121);
sealing the first microelectromechanical device (22; 122) and the second microelectromechanical device (23; 123) respectively in a first chamber (32; 132) and in a second chamber (33; 133) at a first pressure (P₁; P₁');
fluidically coupling the first chamber (32; 132) to an external environment through the substrate (2; 102); and
sealing the first chamber (32; 132) at a second pressure (P₂; P₂') different from the first pressure (P₁; P₁');
wherein fluidically coupling comprises:
forming a cavity (25; 125) fluidically coupled to the first chamber (32; 132) in the dielectric layer (3; 103) and extending from the substrate (2; 102) to a portion of the stop layer (7; 107);
etching the substrate (2; 102) to form a channel (35; 135) through the substrate (2; 102) in a position corresponding to the cavity (25; 125) and the portion of the stop layer (7; 107); and
ending the etching of the substrate (2; 102) against the stop layer (7; 107).

2. The process according to claim 1, comprising forming an anchoring structure (15; 115) extending through the cavity and configured to anchor a fixed portion (22a; 122a) of the first microelectromechanical device (22; 122) to the substrate.

3. The process according to claim 2, wherein the anchoring structure (15; 115) delimits, in the cavity (25; 125), an inner first portion (25a; 125a) and an outer second portion (25b; 125b) and forms fluidic passages (26, 27; 126, 127) between the first portion (25a; 125a) and the second portion (25b; 125b) of the cavity (25; 125).

4. The process according to claim 3, wherein forming the anchoring structure (15; 115) comprises:
opening first trenches (5; 105) in the dielectric layer (3; 103) to the substrate (2; 102), the first trenches (5; 105) extending continuously along respective first closed paths nested one inside the other;
opening second trenches (6; 106) in the dielectric layer (3; 103) to the substrate (2; 102), the second trenches (6; 106) being enclosed inside the first trenches (5; 105) and extending on portions of respective second closed paths nested one inside the other;
wherein a first region (3a; 103a) of the dielectric layer (3; 103), internal to the second trenches (6; 106) and of a shape corresponding to the first portion (25a; 125a) of the cavity (25; 15), and a second region (3b; 103b) of the dielectric layer (3; 103), comprised between the first trenches (5; 105) and the second trenches (6; 106) and of a shape corresponding to the second portion (25b; 125b) of the cavity (25; 15), are connected to each other through portions of the dielectric layer (3; 103) separating second consecutive trenches (6; 106).

5. The process according to claim 4, wherein forming the anchoring structure (15; 115) comprises forming a semiconductor connection and anchoring layer (8; 108) on the stop layer (7; 107), so as to fill the first trenches (5; 105) and the second trenches (6; 106) and respectively form annular first anchoring elements (10; 110) and second anchoring elements (11; 111);
patterning the connection and anchoring layer (8; 108) so as to define an anchoring pad (13; 113) bonded to the second anchoring elements (11; 111) over the first region (3a; 103a) of the dielectric layer (3; 103).

6. The process according to claim 5, comprising selectively removing the connection and anchoring layer (8; 108) and the stop layer (7; 107) so as to open at least one window (12; 112) on the second region (3b; 103b) of the dielectric layer (3; 103) around the anchoring structure (15; 115) and expose a portion of the dielectric layer (3; 103) of a shape corresponding to the window (12; 112).

7. The process according to claim 6, comprising forming a dielectric sacrificial layer (18; 118) in contact with the second region (3b; 103b) of the dielectric layer (3; 103) through the at least one window (12; 112).

8. The process according to claim 7, wherein the sacrificial layer (18; 118) is formed on the stop layer (7; 107).

9. The process according to claim 7 or 8, comprising:
removing the sacrificial layer (18; 118) selectively over the anchoring pad (13; 113); and
forming a semiconductor structural layer (21; 121) on the sacrificial layer and in contact with the anchoring pad (13; 113);
wherein forming the first microelectromechanical device (22; 122) and the second microelectromechanical device (23; 123) comprises etching the structural layer (21; 121) in an anisotropic manner to the sacrificial layer (18; 118).

10. The process according to claim 9, wherein forming the cavity (25; 125) comprises removing the sacrificial layer (18; 118) and removing the first region (3a; 103a) and the second region (3b; 103b) of the dielectric layer (3; 103) through the at least one window (12; 112).

11. The process according to any of claims 3 to 10, wherein the channel (35; 135) is aligned with the first portion (25a; 125a) of the cavity (25; 125).

12. The process according to claim 11, wherein sealing the first chamber (32; 132) at the second pressure (P₂; P₂') comprises depositing a sealing layer (37; 137) on a back side (2a; 102a) of the substrate (2; 102) and through the channel (35; 135).

13. The process according to any of claims 3 to 12, wherein sealing the first chamber (32; 132) at the second pressure (P₂; P₂') comprises fluidically insulating the first portion (25a; 125a) from the rest of the cavity (25; 125) and from the first chamber (32; 132).

14. The process according to any of claims 3 to 13, wherein sealing the first chamber (32; 132) at the second pressure (P₂; P₂') comprises closing the fluidic passages (26, 27; 126, 127) between the first portion (25a; 125a) and the second portion (25b; 125b) of the cavity (25; 125).

15. The process according to any of the preceding claims, wherein sealing the first microelectromechanical device (22; 122) and the second microelectromechanical device (23; 123) comprises bonding a second semiconductor wafer (30; 130) to the first semiconductor wafer (1; 101).

16. A microelectromechanical device comprising:
a substrate (2; 102) of semiconductor material;
a dielectric layer (3; 103) on the substrate (2; 102);
a structural layer (21; 121) of semiconductor material on the dielectric layer (3; 103);
a stop layer (7; 107) interposed between the dielectric layer (3; 103) and the structural layer (21; 121), the substrate (2; 102) being selectively etchable with respect to the stop layer (7; 107);
in the structural layer (21; 121), a first microelectromechanical device (22; 122) and a second microelectromechanical device (23; 123) sealed respectively in a first chamber (32; 132) at a first pressure (P₁; P₁') and in a second chamber (33; 133) at a second pressure (P₂; P₂'), different from the first pressure (P₁; P₁');
a channel (35; 135) traversing the substrate (2; 102);
in the dielectric layer (3; 103) between the substrate (2; 102) and a portion of the stop layer (7; 107), a first cavity (25a; 125a) fluidically coupled to the channel (35), a second cavity (25b ; 125b) fluidically coupled to the first chamber (32; 132) and fluidic passages (26, 27; 126, 127) between the first cavity (25a; 125a) and the second cavity (25b; 125b); and
a sealing layer (37; 137) which closes the fluidic passages (26, 27; 126, 127) and fluidically insulates the first cavity (25a; 125a) from the second cavity (25b; 125b).

## Patentansprüche

1. Verfahren zum Herstellen von mikroelektromechanischen Vorrichtungen, das Folgendes umfasst:
Bilden einer dielektrischen Schicht (3; 103), einer Strukturschicht (21; 121) und einer Stoppschicht (7; 107) zwischen der dielektrischen Schicht (3; 103) und der Strukturschicht (21; 121) auf einem ersten Halbleiterwafer (1; 101), der ein Substrat (2; 102) aus Halbleitermaterial umfasst, wobei das Substrat (2; 102) in Bezug auf die Stoppschicht (7; 107) selektiv ätzbar ist;
Bilden einer ersten mikroelektromechanischen Vorrichtung (22; 122) und einer zweiten mikroelektromechanischen Vorrichtung (23; 123) in der Strukturschicht (21; 121);
Abdichten der ersten mikroelektromechanischen Vorrichtung (22; 122) und der zweiten mikroelektromechanischen Vorrichtung (23; 123) jeweils in einer ersten Kammer (32; 132) und in einer zweiten Kammer (33; 133) bei einem ersten Druck (P₁; P₁');
fluidisches Koppeln der ersten Kammer (32; 132) mit einer äußeren Umgebung durch das Substrat (2; 102); und
Abdichten der ersten Kammer (32; 132) bei einem zweiten Druck (P₂; P₂'), der sich von dem ersten Druck (P₁; P₁') unterscheidet;
wobei das fluidische Koppeln Folgendes umfasst:
Bilden eines Hohlraums (25; 125), der fluidisch mit der ersten Kammer (32; 132) in der dielektrischen Schicht (3; 103) gekoppelt ist und sich von dem Substrat (2; 102) zu einem Abschnitt der Stoppschicht (7; 107) erstreckt;
Ätzen des Substrats (2; 102) zum Bilden eines Kanals (35; 135) durch das Substrat (2; 102) in einer Position, die dem Hohlraum (25; 125) und dem Abschnitt der Stoppschicht (7; 107) entspricht; und
Beenden des Ätzens des Substrats (2; 102) an der Stoppschicht (7; 107).

2. Verfahren nach Anspruch 1, umfassend das Bilden einer Verankerungsstruktur (15; 115), die sich durch den Hohlraum erstreckt und so eingerichtet ist, dass sie einen festen Abschnitt (22a; 122a) der ersten mikroelektromechanischen Vorrichtung (22; 122) am Substrat verankert.

3. Verfahren nach Anspruch 2, wobei die Verankerungsstruktur (15; 115) in dem Hohlraum (25; 125) einen inneren ersten Abschnitt (25a; 125a) und einen äußeren zweiten Abschnitt (25b; 125b) abgrenzt und fluidische Durchgänge (26, 27; 126, 127) zwischen dem ersten Abschnitt (25a; 125a) und dem zweiten Abschnitt (25b; 125b) des Hohlraums (25; 125) bildet.

4. Verfahren nach Anspruch 3, wobei das Bilden der Verankerungsstruktur (15; 115) Folgendes umfasst:
Öffnen erster Gräben (5; 105) in der dielektrischen Schicht (3; 103) bis zu dem Substrat (2; 102), wobei sich die ersten Gräben (5; 105) kontinuierlich entlang jeweiliger erster geschlossener Pfade erstrecken, die ineinander verschachtelt sind;
Öffnen zweiter Gräben (6; 106) in der dielektrischen Schicht (3; 103) bis zu dem Substrat (2; 102), wobei die zweiten Gräben (6; 106) innerhalb der ersten Gräben (5; 105) eingeschlossen sind und sich auf Abschnitte von jeweils zweiten geschlossenen Pfaden erstrecken, die ineinander verschachtelt sind;
wobei ein erster Bereich (3a; 103a) der dielektrischen Schicht (3; 103), der innerhalb der zweiten Gräben (6; 106) liegt und eine Form hat, die dem ersten Abschnitt (25a; 125a) des Hohlraums (25; 15) entspricht, und ein zweiter Bereich (3b; 103b) der dielektrischen Schicht (3; 103), der zwischen den ersten Gräben (5; 105) und den zweiten Gräben (6; 106) liegt und eine Form hat, die dem zweiten Abschnitt (25b; 125b) des Hohlraums (25; 15) entspricht, durch Abschnitte der dielektrischen Schicht (3; 103) miteinander verbunden sind, um zweite aufeinanderfolgende Gräben (6; 106) voneinander zu trennen.

5. Verfahren nach Anspruch 4, wobei das Bilden der Verankerungsstruktur (15; 115) das Bilden einer Halbleiterverbindungs- und Verankerungsschicht (8; 108) auf der Stoppschicht (7; 107) umfasst, um die ersten Gräben (5; 105) und die zweiten Gräben (6; 106) zu füllen und jeweils ringförmige erste Verankerungselemente (10; 110) und zweite Verankerungselemente (11; 111) zu bilden;
Strukturieren der Verbindungs- und Verankerungsschicht (8; 108), um eine mit den zweiten Verankerungselementen (11; 111) über den ersten Bereich (3a; 103a) der dielektrischen Schicht (3; 103) verbundene Verankerungsfläche (13; 113) zu definieren.

6. Verfahren nach Anspruch 5, umfassend das selektive Entfernen der Verbindungs- und Verankerungsschicht (8; 108) und der Stoppschicht (7; 107), um mindestens ein Fenster (12; 112) auf dem zweiten Bereich (3b; 103b) der dielektrischen Schicht (3; 103) um die Verankerungsstruktur (15; 115) herum zu öffnen und einen Abschnitt der dielektrischen Schicht (3; 103) einer dem Fenster (12; 112) entsprechenden Form freizulegen.

7. Verfahren nach Anspruch 6, umfassend das Bilden einer dielektrischen Opferschicht (18; 118), die in Kontakt mit dem zweiten Bereich (3b; 103b) der dielektrischen Schicht (3; 103) durch das mindestens eine Fenster (12; 112) steht.

8. Verfahren nach Anspruch 7, wobei die Opferschicht (18; 118) auf der Stoppschicht (7; 107) gebildet wird.

9. Verfahren nach Anspruch 7 oder 8, das Folgendes umfasst:
selektives Entfernen der Opferschicht (18; 118) über der Verankerungsfläche (13; 113); und
Bilden einer Halbleiterstrukturschicht (21; 121) auf der Opferschicht und in Kontakt mit der Verankerungsfläche (13; 113);
wobei das Bilden der ersten mikroelektromechanischen Vorrichtung (22; 122) und der zweiten mikroelektromechanischen Vorrichtung (23; 123) das anisotrope Ätzen der Strukturschicht (21; 121) bis auf die Opferschicht (18; 118) umfasst.

10. Verfahren nach Anspruch 9, wobei das Bilden des Hohlraums (25; 125) das Entfernen der Opferschicht (18; 118) und das Entfernen des ersten Bereichs (3a; 103a) und des zweiten Bereichs (3b; 103b) der dielektrischen Schicht (3; 103) durch das mindestens eine Fenster (12; 112) umfasst.

11. Verfahren nach einem der Ansprüche 3 bis 10, wobei der Kanal (35; 135) mit dem ersten Abschnitt (25a; 125a) des Hohlraums (25; 125) ausgerichtet ist.

12. Verfahren nach Anspruch 11, wobei das Abdichten der ersten Kammer (32; 132) bei dem zweiten Druck (P₂; P₂') das Auftragen einer Dichtungsschicht (37; 137) auf einer Rückseite (2a; 102a) des Substrats (2; 102) und durch den Kanal (35; 135) umfasst.

13. Verfahren nach einem der Ansprüche 3 bis 12, wobei das Abdichten der ersten Kammer (32; 132) bei dem zweiten Druck (P₂; P₂') das fluidische Isolieren des ersten Abschnitts (25a; 125a) von dem Rest des Hohlraums (25; 125) und von der ersten Kammer (32; 132) umfasst.

14. Verfahren nach einem der Ansprüche 3 bis 13, wobei das Abdichten der ersten Kammer (32; 132) bei dem zweiten Druck (P₂; P₂') das Schließen der fluidischen Durchgängen (26, 27; 126, 127) zwischen dem ersten Abschnitt (25a; 125a) und dem zweiten Abschnitt (25b; 125b) des Hohlraums (25; 125) umfasst.

15. Verfahren nach einem der vorhergehenden Ansprüche, wobei das Abdichten der ersten mikroelektromechanischen Vorrichtung (22; 122) und der zweiten mikroelektromechanischen Vorrichtung (23; 123) das Verbinden eines zweiten Halbleiterwafers (30; 130) mit dem ersten Halbleiterwafer (1; 101) umfasst.

16. Mikroelektromechanische Vorrichtung, umfassend:
ein Substrat (2; 102) aus Halbleitermaterial;
eine dielektrische Schicht (3; 103) auf dem Substrat (2; 102);
eine Strukturschicht (21; 121) aus Halbleitermaterial auf der dielektrischen Schicht (3; 103);
eine Stoppschicht (7; 107), die zwischen der dielektrischen Schicht (3; 103) und der Strukturschicht (21; 121) eingefügt ist, wobei das Substrat (2; 102) in Bezug auf die Stoppschicht (7; 107) selektiv ätzbar ist;
eine erste mikroelektromechanische Vorrichtung (22; 122) und eine zweite mikroelektromechanische Vorrichtung (23; 123), die jeweils in einer ersten Kammer (32; 132) bei einem ersten Druck (P₁; P₁') und in einer zweiten Kammer (33; 133) bei einem zweiten Druck (P₂';), der sich von dem ersten Druck (P₁; P₁') unterscheidet, abgedichtet sind, in der Strukturschicht (21; 121);
einen Kanal (35; 135), der das Substrat (2; 102) durchquert; in der dielektrischen Schicht (3; 103) zwischen dem Substrat (2; 102) und einem Abschnitt der Stoppschicht (7; 107), einen ersten Hohlraum (25a; 125a), der fluidisch mit dem Kanal (35) gekoppelt ist, einen zweiten Hohlraum (25b; 125b), der fluidisch mit der ersten Kammer (32; 132) gekoppelt ist, und fluidische Durchgänge (26, 27; 126, 127) zwischen dem ersten Hohlraum (25a; 125a) und dem zweiten Hohlraum (25b; 125b); und
eine Dichtungsschicht (37; 137), die die fluidischen Durchgänge (26, 27; 126, 127) verschließt und den ersten Hohlraum (25a; 125a) fluidisch von dem zweiten Hohlraum (25b; 125b) isoliert.

## Revendications

1. Processus de fabrication de dispositifs micro-électromécaniques comprenant :
sur une première tranche de semi-conducteur (1; 101) comprenant un substrat (2; 102) de matériau semi-conducteur, de former une couche diélectrique (3; 103), une couche structurelle (21; 121) et une couche d'arrêt (7; 107) entre la couche diélectrique (3; 103) et la couche structurelle (21; 121), le substrat (2; 102) pouvant être gravé sélectivement par rapport à la couche d'arrêt (7; 107) ;
de former un premier dispositif micro-électromécanique (22; 122) et un second dispositif micro-électromécanique (23; 123) dans la couche structurelle (21; 121) ;
de sceller le premier dispositif micro-électromécanique (22; 122) et le second dispositif micro-électromécanique (23; 123) respectivement dans une première chambre (32; 132) et une seconde chambre (33; 133) à une première pression (P₁; P₁') ;
de coupler fluidiquement la première chambre (32; 132) à un environnement extérieur à travers le substrat (2; 102) ; et
de sceller la première chambre (32; 132) à une seconde pression (P₂; P₂') différente de la première pression (P₁; P₁') ;
dans lequel le couplage fluidique comprend :
de former une cavité (25; 125) couplée fluidiquement à la première chambre (32; 132) dans la couche diélectrique (3; 103) et s'étendant depuis le substrat (2; 102) jusqu'à une partie de la couche d'arrêt (7; 107) ;
de graver le substrat (2; 102) pour former un canal (35; 135) à travers le substrat (2; 102) dans une position correspondant à la cavité (25; 125) et la partie de la couche d'arrêt (7; 107) ; et
de finir la gravure du substrat (2; 102) contre la couche d'arrêt (7; 107).

2. Processus selon la revendication 1, comprenant de former une structure d'ancrage (15; 115) s'étendant à travers la cavité et configurée pour ancrer une partie fixe (22a; 122a) du premier dispositif micro-électromécanique (22; 122) sur le substrat.

3. Processus selon la revendication 2, dans lequel la structure d'ancrage (15; 115) délimite, dans la cavité (25; 125), une première partie intérieure (25a; 125a) et une seconde partie extérieure (25b; 125b) et forme des passages fluidiques (26, 27; 126, 127) entre la première partie (25a; 125a) et la seconde partie (25b; 125b) de la cavité (25; 125).

4. Processus selon la revendication 3, dans lequel former la structure d'ancrage (15; 115) comprend :
d'ouvrir des premières tranchées (5; 105) dans la couche diélectrique (3; 103) jusqu'au substrat (2; 102), les premières tranchées (5; 105) s'étendant continument le long de premiers trajets fermés respectifs nichés l'un à l'intérieur de l'autre ;
d'ouvrir des secondes tranchées (6; 106) dans la couche diélectrique (3; 103) jusqu'au substrat (2; 102), les secondes tranchées (6; 106) étant enfermées à l'intérieur des premières tranchées (5; 105) et s'étendant sur des parties de second trajets fermés respectifs nichés l'un à l'intérieur de l'autre ;
dans lequel une première région (3a; 103a) de la couche diélectrique (3; 103), interne aux secondes tranchées (6; 106) et d'une forme correspondant à la première partie (25a; 125a) de la cavité (25; 125), et une seconde région (3b; 103b) de la couche diélectrique (3; 103), comprise entre les premières tranchées (5; 105) et les secondes tranchées (6; 106) et d'une forme correspondant à la seconde partie (25b; 125b) de la cavité (25; 125), sont connectées l'une à l'autre à travers des parties de la couche diélectrique (3; 103) séparant des secondes tranchées (6; 106).

5. Processus selon la revendication 4, dans lequel former la structure d'ancrage (15; 115) comprend de former une couche d'ancrage et de connexion de semi-conducteur (8; 108) sur la couche d'arrêt (7; 107), de façon à remplir les premières tranchées (5; 105) et les secondes tranchées (6; 106) et former respectivement des seconds éléments d'ancrage (11; 111) et des premiers éléments d'ancrage (10; 110) annulaires ;
de mettre en forme la couche d'ancrage et de connexion (8; 108) de façon à définir un plot d'ancrage (13; 113) collé sur les seconds éléments d'ancrage (11; 111) au-dessus de la première région (3a; 103a) de la couche diélectrique (3; 103).

6. Processus selon la revendication 5, comprenant d'enlever sélectivement la couche d'ancrage et de connexion (8; 108) et la couche d'arrêt (7; 107) de façon à ouvrir au moins une fenêtre (12; 112) sur la seconde région (3b; 103b) de la couche diélectrique (3; 103) autour de la structure d'ancrage (15; 115) et exposer une partie de la couche diélectrique (3; 103) d'une forme correspondant à la fenêtre (12; 112).

7. Processus selon la revendication 6, comprenant de former une couche sacrificielle diélectrique (18; 118) en contact avec la seconde région (3b; 103b) de la couche diélectrique (3; 103) à travers l'au moins une fenêtre (12; 112).

8. Processus selon la revendication 7, dans lequel la couche sacrificielle (18; 118) est formée sur la couche d'arrêt (7; 107).

9. Processus selon la revendication 7 ou 8, comprenant
d'enlever la couche sacrificielle (18; 118) sélectivement au-dessus du plot d'ancrage (13; 113) ; et
de former une couche structurelle (21; 121) de semi-conducteur sur la couche sacrificielle et en contact avec le plot d'ancrage (13; 113) ;
dans lequel former le premier dispositif micro-électromécanique (22; 122) et le second dispositif micro-électromécanique (23; 123) comprend de graver la couche structurelle (21; 121) d'une manière anisotropique jusqu'à la couche sacrificielle (18; 118).

10. Processus selon la revendication 9, dans lequel former la cavité (25; 125) comprend d'enlever la couche sacrificielle (18; 118) et d'enlever la première région (3a; 103a) et la seconde région (3b; 103b) de la couche diélectrique (3; 103) à travers l'au moins une fenêtre (12; 112).

11. Processus selon l'une quelconque des revendications 3 à 10, dans lequel le canal (35; 135) est aligné avec la première partie (25a; 125a) de la cavité (25; 125).

12. Processus selon la revendication 11, dans lequel sceller la première chambre (32; 132) à la seconde pression (P₂; P₂') comprend de déposer une couche de scellement (37; 137) sur un côté arrière (2a; 102a) du substrat (2; 102) et à travers le canal (35; 135).

13. Processus selon l'une quelconque des revendications 3 à 12, dans lequel sceller la première chambre (32; 132) à la seconde pression (P₂; P₂') comprend d'isoler fluidiquement la première partie (25a; 125a) du reste de la cavité (25; 125) et de la première chambre (32; 132).

14. Processus selon l'une quelconque des revendications 3 à 13, dans lequel sceller la première chambre (32; 132) à la seconde pression (P₂; P₂') comprend de fermer les passages fluidiques (26, 27; 126; 127) entre la première partie (25a; 125a) et la seconde partie (25b; 125b) de la cavité (25; 125).

15. Processus selon l'une quelconque des revendications précédentes, dans lequel sceller le premier dispositif micro-électromécanique (22; 122) et le second dispositif micro-électromécanique (23; 123) comprend de coller une seconde tranche de semi-conducteur (30; 130) sur la première tranche de semi-conducteur (1; 101).

16. Dispositif micro-électromécanique comprenant :
un substrat (2; 102) de matériau semi-conducteur ;
une couche diélectrique (3; 103) sur le substrat (2; 102) ;
une couche structurelle (21; 121) de matériau semi-conducteur sur la couche diélectrique (3; 103) ;
une couche d'arrêt (7; 107) intercalée entre la couche diélectrique (3; 103) et la couche structurelle (21; 121), le substrat (2; 102) pouvant être gravé sélectivement par rapport à la couche d'arrêt (7; 107) ;
dans la couche structurelle (21; 121), un premier dispositif micro-électromécanique (22; 122) et un second dispositif micro-électromécanique (23; 123) scellés respectivement dans une première chambre (32; 132) à une première pression (P₁; P₁') et dans une seconde chambre (33; 133) à une seconde pression (P₂; P₂') différente de la première pression (P₁; P₁') ;
un canal (35; 135) traversant le substrat (2; 102) ;
dans la couche diélectrique (3; 103) entre le substrat (2; 102) et une partie de la couche d'arrêt (7; 107), une première cavité (25a; 125a) couplée fluidiquement au canal (35), une seconde cavité (25b; 125b) couplée fluidiquement à la première chambre (32; 132) et des passages fluidiques (26, 27; 126, 127) entre la première cavité (25a; 125a) et la seconde cavité (25b; 125b) ; et
une couche de scellement (37; 137) qui ferme les passages fluidiques (26, 27; 126, 127) et isole fluidiquement la première cavité (25a; 125a) de la seconde cavité (25b; 125b).
